# DEMANDE DE BREVET EUROPEEN

(11) **EP 2 744 032 A1**
(43) Date de publication de la demande: **18.06.2014**
(21) Numéro de dépôt: 13196325.8
(22) Date de dépôt: 09.12.2013
(51) Int. Cl.: H01M 10/42, A47B 21/03, G06F 1/16, G06F 1/18, H01M 10/48

(54) **Support comprenant une batterie rechargeable et amovible pour alimenter un appareil de traitement de données, système mobile de traitement de données et installation de gestion d'une pluralité de batteries**

(30) Priorité: 11.12.2012 FR 1261905
(71) Demandeur: Tactys, 76160 Saint Jacques Sur Darnetal (FR)
(72) Inventeur: MAUGER, Manuelle, 92140 CLAMART (FR); RONDEAU, Patrick, 76130 MONT SAINT AIGNAN (FR)
(74) Mandataire: Pontet Allano & Associes

(57) **Abrégé**

L'invention concerne un support comprenant une batterie rechargeable et amovible pour alimenter un appareil de traitement de données, système mobile de traitement de données et installation de gestion d'une pluralité de batteries. La batterie (100) électrique rechargeable et amovible comprend :
- au moins un moyen (102) de stockage de l'énergie électrique,
- des moyens (106,110,112), dits moyens de liaison électrique de batterie, pour relier électriquement et de manière amovible, ledit moyen (102) de stockage à un dispositif externe pour charger/décharger électriquement ledit moyen (102) de stockage, et
- au moins un moyen (114,116), dit moyen de communication de batterie, pour communiquer, selon au moins un protocole de communication, au moins une donnée numérique relative à ladite batterie à un dispositif externe lorsque ladite batterie (100) est en charge ou en décharge.

## Description

La présente invention concerne une batterie électrique rechargeable, et plus particulièrement une batterie électrique rechargeable et amovible pour un système mobile/nomade de traitement de données. Elle concerne également un support d'accueil pour recevoir une telle batterie et un système mobile de traitement de données équipé d'une telle batterie ou d'un tel support.

Le domaine de l'invention est le domaine des appareils mobiles de traitement de données fonctionnant avec une ou des batteries rechargeables fournissant un signal électrique d'alimentation nécessaire à leur fonctionnement. L'invention concerne plus particulièrement, le domaine des chariots mobiles de traitement de données destinés à être utilisés dans un site, tel qu'un hôpital, nécessitant un traitement de données nomade, c'est-à-dire un traitement de données dans plusieurs pièces ou emplacement du site.

### Etat de la technique

Actuellement, il existe de nombreux systèmes mobiles de traitement de données tels que celui décrit dans la demande de brevet publiée sous le numéro FR 2 968 909 A1**.**

Ce système comprend une platine munie de deux emplacements, chacun des emplacements étant agencé pour recevoir de manière indépendante et escamotable une batterie fournissant un signal électrique alimentant les moyens de traitement de données du système. Chaque emplacement est agencé pour connecter, de manière indépendante, une batterie disposée dans l'emplacement à un circuit d'alimentation des moyens de traitement de données.

Ainsi, il est possible avec un tel système de changer de batterie sans perturber ou couper le traitement des données : pendant que le système est utilisé avec une première batterie, une deuxième batterie peut être mise en charge, et lorsque la première batterie a un niveau de charge faible la deuxième batterie est connectée avant d'enlever la première batterie.

Cependant, ce système et les batteries utilisées dans ces systèmes présentent encore des inconvénients.

Par exemple, il n'est pas possible, avec un tel système et de telles batteries, d'éviter une panne du système causée par une batterie en fin de vie ou d'une batterie dont la capacité nominale est trop faible. Un tel inconvénient peut être problématique et fréquent surtout lorsque, sur un site donné, plusieurs systèmes de traitement de données utilisent de manière partagée et interchangeable des batteries rechargeables.

Un but de la présente invention est de remédier aux inconvénients précités.

Un autre but de l'invention est de proposer une batterie rechargeable et amovible permettant de réaliser une gestion flux flexible, plus simple et plus complète de la batterie.

Un autre but de la présente invention est de proposer une batterie rechargeable et amovible permettant d'avoir accès plus facilement et de manière plus flexible à des informations concernant la batterie.

### Enoncé de l'invention

L'invention propose d'atteindre au moins un de ces buts par une batterie électrique rechargeable et amovible comprenant :
- au moins un moyen de stockage de l'énergie électrique,
- des moyens, dit moyens de liaison électrique de batterie, pour relier électriquement et de manière amovible, ledit moyen de stockage à un dispositif externe pour charger/décharger électriquement ledit moyen de stockage, et
- au moins un moyen, dit moyen de communication de batterie, pour communiquer, selon au moins un protocole de communication, au moins une donnée numérique relative à ladite batterie à un dispositif externe lorsque ladite batterie est en charge ou en décharge.

Ainsi, la batterie selon l'invention comprend au moins un moyen de communication pour communiquer des données relatives à la batterie à chaque fois que la batterie est utilisée, soit pour un cycle de charge soit pour un cycle de décharge. Il est ainsi possible de suivre la batterie tout au long des cycles d'utilisation et de réaliser une gestion flexible et continue dans le temps de la batterie.

De plus, la gestion de la batterie selon l'invention est plus flexible et plus simple. Une telle gestion n'est pas limitée à une zone géographique, puisque que quelle que soit la zone d'utilisation de la batterie, les données relatives à la batterie peuvent être remontées vers un dispositif externe et consultées, éventuellement au travers d'un réseau de communication. Ces informations peuvent par conséquent être gérées de manière centralisée indépendamment de la zone où se trouve la batterie et des opérations de maintenance sur la batterie peuvent être déclenchées de manière centralisée et à distance.

En outre, la batterie peut être utilisée de manière plus flexible sans avoir à se soucier du lieu de son utilisation.

De plus, la maintenance d'un groupe de batteries selon l'invention est moins consommateur en temps et moins onéreuse puisque les informations sont remontées à chaque utilisation d'une batterie vers un dispositif externe centralisant les données relatives à toutes les batteries. Il n'est donc pas nécessaire de prévoir des interventions de contrôle automatiques pour recueillir les informations d'utilisation des batteries, de telles interventions impliquant forcément une identification du lieu où se trouve la batterie, et un déplacement vers ce lieu.

Le dispositif externe peut être un appareil informatique de supervision/gestion :
- directement accédé par le moyen de communication au travers d'un réseau de communication, ou
- accédé indirectement par le moyen de communication, par exemple en passant par un support de communication, éventuellement relié à un appareil de traitement de données, le support ou l'appareil étant connecté audit appareil de supervision/gestion au travers d'un réseau de communication.

L'appareil de traitement de données peut en outre être alimenté par la batterie.

Avantageusement, la batterie peut en outre comprendre un module de traitement pour déterminer, à partir d'une valeur d'une grandeur mesurée, au moins une donnée relative au moyen de stockage.

Un tel module peut être un processeur ou un calculateur qui, en fonction des valeurs de grandeurs électriques mesurées, détermine des données numériques relatives à la capacité résiduelle de charge, le nombre de charges réalisées, le nombre de charges complètes, le nombre de décharge, le nombre de décharges complètes, etc.

Avantageusement, un tel module peut être numérique.

Alternativement un tel module de traitement peut être agencé sur un support d'accueil ou sur un appareil externe, tel que par exemple un appareil de traitement de données alimenté par la batterie.

La batterie selon l'invention peut en outre comprendre un moyen de mémorisation d'au moins une donnée.

Un tel moyen de mémorisation peut par exemple comprendre une mémoire flash.

Une telle donnée mémorisée peut comprendre la ou une partie des données relative à un état de la batterie ou encore une donnée d'identification de la batterie, une donnée d'identification d'une zone, d'un service ou d'un utilisateur de la batterie, etc.

Dans un exemple de réalisation avantageux, le moyen de mémorisation est accessible en lecture et en écriture au module de traitement.

Ainsi, le module de traitement peut mesurer traiter/modifier une donnée mémorisée ou mémoriser une donnée à un instant t1 et lire la donnée modifiée à un instant t2 pour la communiquer à un dispositif externe ou pour déterminer une donnée à communiquer.

La batterie selon l'invention peut en outre comprendre un moyen de mesure d'une valeur d'une grandeur électrique relative audit moyen de stockage.

Une telle grandeur physique peut être par exemple le niveau de courant ou le niveau de tension présent aux bornes du moyen de stockage. Dans ce cas, le moyen de mesure comprend un ampèremètre, respectivement un voltmètre, positionné en série, respectivement en parallèle, entre la cathode et l'anode du moyen de stockage.

Une telle grandeur physique peut alternativement être mesurée par l'intermédiaire des moyens de liaison électrique, qui dans un exemple de réalisation comprend deux électrodes : une anode et une cathode.

Le moyen de communication de batterie peut comprendre un moyen de communication par contact.

Un tel moyen de communication peut comprendre un ou des connecteurs de type USB, RS232 ou encore RJ45 ou tout connecteur en série ou en parallèle.

Le moyen de communication de batterie peut comprendre, alternativement ou en plus, un moyen de communication sans fil.

Un tel moyen de communication peut comprendre un moyen de communication de type Bluetooth®, Wifi®, ou encore tout moyen de communication par onde radio ou optique, plus particulièrement un moyen de communication par rayonnement infrarouge connu sous le sigle IrDA.

Avantageusement, la batterie selon l'invention se présente, dans un mode de réalisation préféré, sous la forme d'un ensemble monobloc, facile à manipuler.

Par exemple, la batterie selon l'invention peut comprendre une enveloppe, dite externe, dans/sur laquelle sont agencés tous les composants dudit dispositifs.

Ainsi, l'enveloppe externe peut comprendre/comporter le moyen de stockage, le moyen de liaison électrique de batterie, le moyen de communication de batterie, le module de traitement, le moyen de mesure, le moyen de mémorisation.

Avantageusement, l'enveloppe externe peut comporter une ouverture pour laisser accès aux moyens de liaison électrique de batterie et/ou au moyen de communication de batterie.

Alternativement les moyens de liaison électrique de batterie ou le moyen de communication peuvent être disposé(s) sur une paroi externe de l'enveloppe externe.

La batterie selon l'invention peut en outre comprendre des moyens visuels ou sonores pour surveiller le niveau de charge du moyen de stockage. Les moyens pour surveiller le niveau de charge peuvent comprendre un ou plusieurs indicateurs lumineux renseignant l'utilisateur sur le niveau de charge du moyen de stockage.

Lorsque la batterie est disposée dans une enveloppe, les moyens pour surveiller le niveau de charge d'une batterie peuvent être disposés sur cette enveloppe.

L'enveloppe peut être réalisée en un matériau rigide, tel qu'un matériau métallique.

Selon un autre aspect de l'invention il est proposé un support pour accueillir de manière amovible au moins une batterie selon l'invention, ledit support comprenant un ou plusieurs compartiments, dit d'accueil, pour recevoir chacun une batterie, chaque compartiment d'accueil comprenant :
- des premiers moyens de liaison électriques pour réaliser une liaison électrique avec les moyens de liaison électriques de batterie,
- des deuxièmes moyens de liaison électriques pour réaliser, au moins indirectement, une liaison électrique avec au moins un dispositif externe, qui peut être un appareil de traitement de données alimenté par les batteries ou une source d'énergie pour charger la batterie,
- au moins un premier moyen de communication pour communiquer avec le moyen de communication de batterie, et
- au moins un deuxième moyen de communication pour communiquer avec un dispositif externe, qui peut être un appareil de traitement de données alimenté par la batterie ou un appareil de supervision distant pour recevoir et mémoriser les données en vue de les traiter et de réaliser une gestion de batteries.

Ainsi, un tel support peut être utilisé soit pour le chargement de la ou des batteries avec un signal provenant d'une source externe tel qu'un réseau de distribution d'électricité soit pour l'alimentation d'un système mobile de traitement de données comprenant au moins un appareil de traitement de données.

Dans la présente demande, l'expression « traitement de données » peut comprendre toutes opérations effectuées sur/avec des données, telles que par exemple la saisie de données, la consultation de données, l'impression de données, l'envoi et la réception de données, la transformation de données, la mémorisation de données, la lecture ou l'écriture de données, etc.

Chacun des premier et deuxième moyens de communication peut être filaire ou sans fil.

Avantageusement au moins un compartiment d'accueil, préférentiellement chaque compartiment d'accueil, du support selon l'invention peut en outre comprendre :
- au moins un moyen pour guider une batterie lorsque qu'elle est placée dans ledit compartiment ou enlevée dudit compartiment, et/ou
- au moins un moyen pour maintenir une batterie positionnée dans ledit compartiment d'accueil

Pour au moins un, avantageusement chaque, compartiment d'accueil les premiers moyens de liaison électrique et/ou le premier moyen de communication peu(ven)t être disposé(s) sur une surface du fond dudit compartiment d'accueil de sorte que lesdits moyens de liaison électrique et/ou ledit premier moyen de communication sont positionnés en contact avec/en regard, respectivement, les/des moyens de liaison électrique de batterie et/ou le/du moyen de communication de batterie, uniquement sous le poids de ladite batterie.

Avantageusement, les moyens de liaison électrique peuvent comprendre une pièce mâle et les premiers moyens de liaison électrique du support peuvent comprendre une pièce femelle ou un logement dans laquelle ladite pièce mâle s'insère.

Dans un exemple de réalisation préféré de la batterie et du support :
- les moyens de liaison électrique de batterie peuvent comprendre deux électrodes, dites de batterie, disposées sur une pièce mâle faisant saillie de la face inférieure de la batterie. Chaque électrode est composée d'une ou plusieurs lamelles réalisées en un matériau conducteur et déformable élastiquement ;
- les premiers moyens de liaison électrique du support comprennent deux électrodes, dites de support, disposées dans une ouverture prévue pour recevoir la pièce mâle et aménagée dans le fond du logement d'accueil. Les électrodes de support sont positionnées de sorte à être en regard des électrodes de batterie lorsque la pièce mêle s'insère dans la pièce femelle.

Dans cet exemple de réalisation, lorsque la pièce mâle s'insère dans l'ouverture, les lamelles de chaque électrode de batterie sont comprimées élastiquement et réalisent une connexion physique avec chacune des électrodes de support se trouvant dans l'ouverture, réalisant ainsi un contact électrique.

Suivant un mode de réalisation préféré, pour au moins un emplacement d'accueil, le premier moyen de communication peut comprendre un moyen de communication sans fil et le deuxième moyen de communication peut comprendre un moyen de communication filaire avec un appareil de traitement de données constituant un noeud de communication avec un appareil de gestion distant au travers d'un réseau de communication.

Selon un autre aspect de l'invention, il est proposé un système mobile de traitement de données comprenant :
- au moins un moyen de traitement de données, et
- au moins support d'accueil selon l'invention pour accueillir au moins une, préférentiellement deux, batterie(s) selon l'invention.

Un tel système peut se présenter préférentiellement sous la forme d'un chariot mobile, et plus particulièrement un chariot mobile de saisie/lecture/impression de données dans un site, tel qu'un hôpital ou tout autre site nécessitant un traitement de données nomade.

Selon encore un autre aspect de l'invention, il est proposé une installation de gestion d'une pluralité de batteries rechargeables et amovibles selon l'invention, caractérisée en ce qu'elle comprend :
- au moins un support d'accueil, dit de charge, selon l'invention pour charger lesdites batteries,
- au moins un support d'accueil, dit d'alimentation, selon l'invention pour alimenter au moins un appareil de traitement de données,
- au moins un appareil informatique de gestion/supervision distant desdits supports de charge et d'alimentation pour recevoir, au travers d'un réseau de communication, des données en provenance de chacun desdits supports, et éventuellement mémoriser lesdites données reçues, et
- au moins un module d'analyse pour analyser lesdites données reçues en vue de détecter une anomalie sur une batterie et préconiser une opération relative à ladite batterie.

Le module d'analyse peut être avantageusement intégré dans l'appareil distant.

D'autres avantages et caractéristiques de l'invention apparaîtront à l'examen de la description détaillée d'un mode de mise en oeuvre nullement limitatif, et des dessins annexés sur lesquels :
- la FIGURE 1 est une représentation schématique d'une batterie selon l'invention selon l'une vue de côté ;
- la FIGURE 2 est une représentation schématique, selon une vue de dessous, de la batterie de la figure 1 ;
- la FIGURE 3 est une représentation schématique, selon une vue de dessus, d'un support selon l'invention ;
- la FIGURE 4 est une représentation schématique, selon une vue de dessous, du support de la FIGURE 4 ;
- les FIGURES 5 et 6 sont des représentations schématiques d'un système de traitement mobile selon l'invention ; et
- la FGURE 7 est une représentation schématique d'une installation de gestion selon l'invention.

Il est bien entendu que les modes/exemples de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieur. Cette sélection comprend au moins une caractéristique de préférence fonctionnelle sans détails structurels, ou avec seulement une partie des détails structurels si cette partie uniquement est suffisante pour conférer un avantage technique ou pour différencier l'invention par rapport à l'état de la technique antérieur.

En particulier toutes les variantes et tous les modes/exemple de réalisation décrits sont combinables entre eux si rien ne s'oppose à cette combinaison sur le plan technique.

Sur les figures, les éléments communs à plusieurs figures conservent les mêmes références.

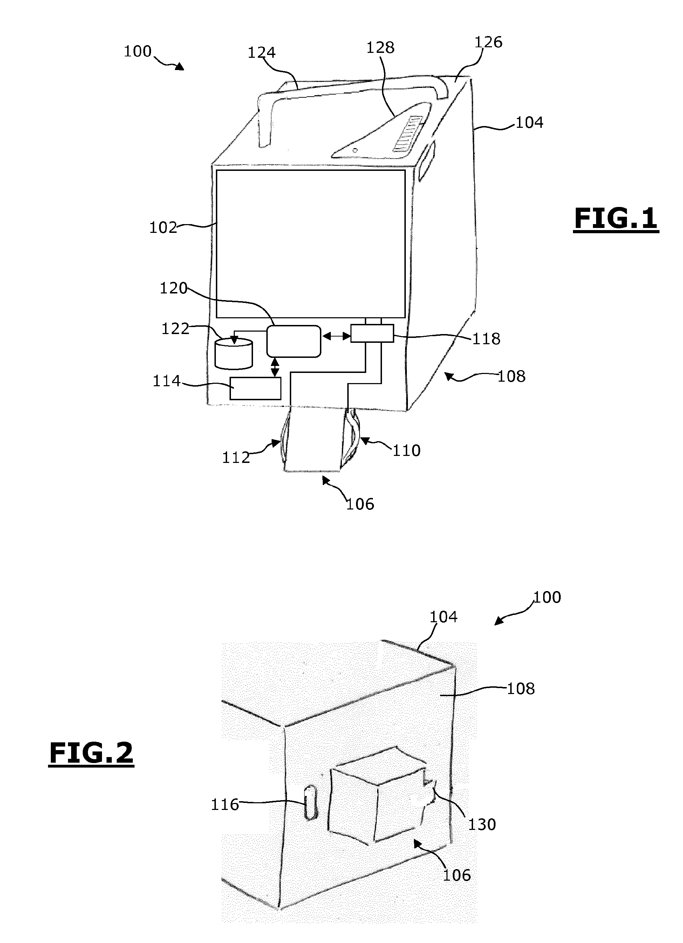

La FIGURE 1 est une représentation schématique d'un exemple de batterie selon l'invention selon une vue de côté et la FIGURE 2 est une représentation schématique partielle de la même batterie selon une vue de dessous.

La batterie 100 représentée sur les FIGURES 1 et 2 comprend un moyen 102 de stockage d'énergie électrique qui est un moyen de stockage standard disposé dans une enveloppe externe 104.

La batterie 100 comprend en outre une pièce 106, mâle, agencée sur la paroi de fond 108 de l'enveloppe externe 104, faisant saillie de cette paroi de fond 108 et comportant deux électrodes 110 et 112 pour relier le moyen de stockage 102 d'énergie électrique avec un dispositif externe, soit pour charger le moyen de stockage 102 depuis le dispositif externe qui est alors une source d'énergie électrique soit pour alimenter le dispositif externe avec un signal électrique provenant du moyen de stockage. Chaque électrode 110,112 comprend une ou plusieurs lamelles (non représentées), chacune réalisée en un matériau électriquement conducteur et déformable élastiquement.

La batterie 102 comprend en outre un module 114 de communication infrarouge, bidirectionnelle avec un dispositif externe, au travers d'une ouverture 116 aménagée sur la paroi de fond 108 de l'enveloppe externe 104. Le module de communication 114 est disposé dans l'enveloppe externe 104 de la batterie 100.

La batterie 100 comprend en outre un module 118 de mesure d'une grandeur physique aux bornes du moyen de stockage 102. Ce module de mesure 118 comprend un ampèremètre et un voltmètre et permet de mesurer la tension et l'ampérage du signal électrique délivré par/vers le moyen de stockage 102.

La batterie 100 comprend également un module numérique 120 de traitement de données, qui peut être un processeur numérique, et des moyens de mémorisation 122, qui peuvent être une/des mémoire(s) flash, accessible(s), en lecture et/ou en écriture, au module de traitement de données 120.

Le module de traitement de données 120 est relié au module de mesure 118 et réalise un traitement des grandeurs mesurées par le module de mesure 118. Le module de traitement de données 120 peut également commander le module de mesure 118 pour initier une mesure d'une grandeur.

Le module de traitement de données 120 peut également écrire les valeurs mesurées et/ou les données obtenues par traitement dans les moyens de mémorisation 122.

Le module de traitement de données 120 est également relié au module de communication 114 d'une part pour traiter les requêtes qui peuvent être reçues par le module de communication 114 et d'autre part pour lui transmettre les données à communiquer à l'appareil externe, ces données étant préalablement lues depuis les moyens de mémorisation 122 ou mesurées par le module de mesure 118, sur demande du module de traitement de données 120 par exemple.

La batterie 100 peut en outre comprendre une poignée 124, attachée à la surface supérieure 126 de l'enveloppe externe 104 opposée à la surface de fond 108 de l'enveloppe externe 104, pour transporter la batterie 100 et des moyens 128 de signalisation visuelle du niveau de charge du moyen de stockage 102, se présentant sous la forme d'un ou plusieurs voyants de couleur identique ou différente.

En outre, la pièce mâle 106 comporte une forme 130 de guidage permettant de positionner correctement et guider la batterie 100 lorsqu'elle est utilisée.

Telle que représentée sur la FIGURE 1, la batterie 100 forme un ensemble monobloc de section rectangulaire ou carrée.

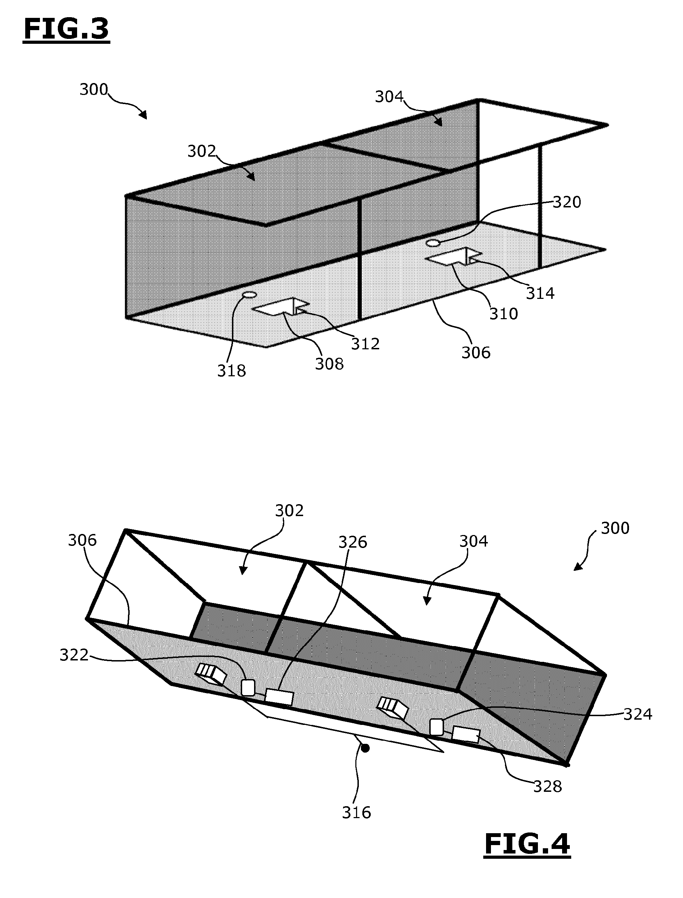

La FIGURE 3 est une représentation schématique, selon une vue de dessus d'un support selon l'invention. La FIGURE 4 est une représentation schématique, selon une vue de dessous, du support de la FIGURE 3.

Le support d'accueil 300 comprend deux emplacements d'accueil 302 et 304. Chacun des emplacements d'accueil 302 et 304 est prévu pour recevoir une batterie (non représentée sur les FIGURES 3 et 4) indépendamment de l'autre. Ainsi, il est possible de disposer et d'enlever une batterie d'un des emplacements 302 et 304 indépendamment de l'autre des emplacements.

Le support d'accueil 300 comprend une plaque métallique de fond 306 constituant le fond de chaque emplacement 302 et 304.

Chacun des emplacements 302 et 304 comprend un logement, respectivement 308 et 310, aménagé dans la plaque métallique de fond 306, prévue pour recevoir la pièce mâle 106 de la batterie 100, de forme sensiblement identique à la forme de la pièce mâle 106 et de dimensions sensiblement supérieures aux dimensions de la pièce mâle 106 de la batterie 100.

Chacun des logements 308 et 310 comprend une forme, respectivement 312 et 314, prévue pour coopérer avec la forme 130 de la pièce mâle 106 pour positionner et guider la batterie lorsqu'elle est placée dans l'emplacement d'accueil concerné.

Chaque logement 308 et 310 comporte également des premiers moyens de liaison électrique consistant en deux électrodes (non représentés) prévus pour coopérer avec les électrodes 110 et 112 de la batterie pour créer une liaison électrique entre le support d'accueil 300 et la batterie 100. Lorsque la batterie 100 est placée dans un emplacement d'accueil 302 ou 304 la pièce mâle 106 s'insère dans le logement 308 ou 310, les électrodes 110 et 112 sont alors déformées élastiquement, sous le poids de la batterie, et viennent en contact des électrodes présentes dans le logement 308 ou 310.

Les électrodes de chaque logement 308 et 310 sont reliés à un deuxième moyen de connexion électrique consistant en un connecteur électrique ou interface électrique 316, telle qu'une prise électrique, prévue pour y connecter un dispositif externe à alimenter par la batterie, ou alimentant la batterie, disposée dans l'emplacement d'accueil, respectivement 302 et 304.

Chaque emplacement d'accueil 302 et 304 comporte également une ouverture ou fenêtre, respectivement 318 et 320, de communication par infrarouge avec un premier module de communication, respectivement 322 et 324. Chaque emplacement comporte également un deuxième module de communication, respectivement 326 et 328, pour communiquer avec un dispositif externe, qui peut être un appareil de traitement de données alimenté par les batteries ou un appareil de supervision/gestion.

Lorsque la ou les batteries et le support d'accueil sont utilisés pour alimenter un appareil, par exemple de traitement de données, muni de moyens de connexion à un réseau sans fil, par exemple des moyens de connexion de type WIFI, alors le deuxième module de communication 326 et 328 peut être un module de communication filaire, de type USB, avec un tel appareil de traitement de données qui réalise une passerelle de communication entre le support d'accueil et un appareil de supervision.

Dans le cas contraire, le deuxième module de communication 326 et 328 peut être un module de connexion à un réseau sans fil, par exemple un module de connexion de type WIFI, pour communiquer avec l'appareil de supervision.

Dans tous les cas, le support d'accueil constitue une passerelle de communication entre d'une part chaque batterie et d'autre part soit un appareil de supervision, soit un appareil externe qui lui-même constitue une passerelle entre le support d'accueil et l'appareil de supervision.

Le support 300 peut en outre comprendre des moyens de conversion de données/protocole entre le premier module de communication et le deuxième module de communication.

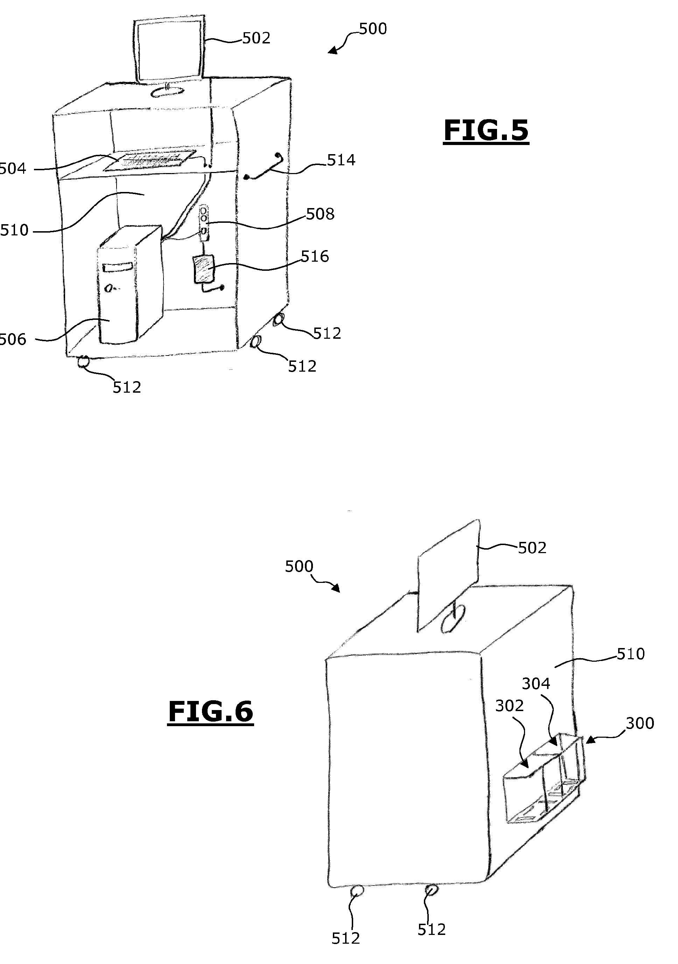

Les FIGURES 5 et 6 sont des représentations schématiques d'un système de traitement mobile selon l'invention, respectivement selon une vue de devant et une vue de derrière.

Le système de traitement de données représenté sur les FIGURES 5 et 6 se présente sous la forme d'un chariot mobile 500.

Le chariot mobile 500 comprend des moyens de traitement de données, à savoir, un écran 502 et un clavier 504 qui sont reliés à une unité centrale 506. Le chariot mobile 500 peut en outre comprendre une imprimante (non représentée).

L'unité centrale 506, et l'écran 502 sont connectés à une prise de courant 508 qui délivre l'électricité alimentant l'unité centrale 506 et l'écran 502. La prise de courant 508 peut être le deuxième moyen de connexion électrique 316 du support d'accueil 300 représenté sur la FIGURE 4.

D'autres moyens de traitement de données, par exemple une imprimante, peuvent être alimentés par cette prise de courant 508. La prise de courant 508 est fixée sur la face interne de la paroi arrière 510 du chariot 500.

Le chariot 500 comprend en outre un support d'accueil pour accueillir au moins une batterie, par exemple le support d'accueil 300 des FIGURES 3 et 4, fixé sur la face externe de la paroi arrière 510 avec des vis ou des moyens de collage.

Le chariot 500 comprend en outre plusieurs roues 512 permettant de déplacer le chariot 500 et une poignée 514 pour faciliter la manipulation du chariot 500.

Le chariot peut en outre comprendre un transformateur de courant/tension 516 positionnée en amont de la prise 508.

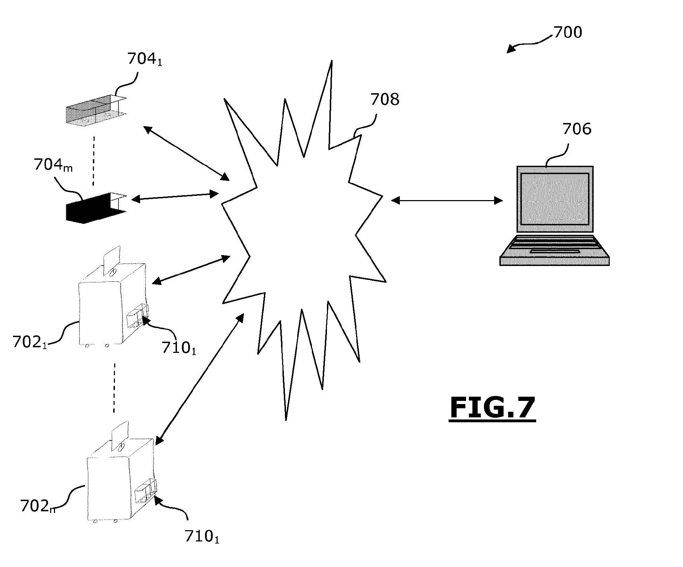

La FIGURE 7 est une représentation schématique d'une installation de gestion de batteries selon l'invention.

L'installation 700 représentée sur la FIGURE 7 comprend plusieurs systèmes de traitement de données 702₁-702ₙ, éventuellement identiques ou similaires au chariot 500 représenté sur les FIGURES 5 et 6, utilisés dans les phases de décharge des batteries.

L'installation comprend également une pluralité de supports 704₁-704ₘ, éventuellement identiques ou similaires au support 300 représenté sur les FIGURES 3 et 4, utilisés pour recharger les batteries, par exemple à partir du réseau électrique.

Chacune des batteries en décharge dans chacun des systèmes de traitement de données 702 est reliée à un appareil de supervision 706, au travers d'un réseau de communication 708, par une connexion, respectivement sans fils.

Chacune des batteries en charge sur chacun des supports 704 est également reliée à l'appareil de supervision 706, au travers d'un réseau de communication, qui peut être le réseau de communication 708, soit par une connexion filaire soit par une connexion sans fil.

Chaque système de traitement de données 702₁-702ₙ est équipé d'un support d'accueil, respectivement 710₁-710ₙ, pour accueillir des batteries 100 pour alimenter le ou les moyens de traitement de données de ces systèmes 702. Chaque support 710 peut être identique ou similaire au support 704 et/ou au support 300 représenté sur les FIGURES 3 et 4

L'échange de données entre chacune batteries et l'appareil de supervision 706 peut être initiée par des requêtes émises par l'appareil de supervision 706, ou à fréquence régulière, ou encore dès modification d'un état d'une batterie.

Chaque batterie comprend un module de mesure, par exemple le module de mesure 118, comprenant :
- un capteur de courant, placé en série avec le moyen de stockage de la batterie et fournissant la valeur du courant aux bornes du moyen de stockage de la batterie lors de la charge et/ou la décharge du moyen de stockage ; et
- un capteur de tension, placé en parallèle avec le moyen de stockage de la batterie et fournissant la valeur de la tension aux bornes du moyen de stockage de la batterie lors de la charge et/ou la décharge du moyen de stockage.

Chacun de ces capteurs comprend un convertisseur analogique/numérique delta/sigma 18 bits.

Les valeurs mesurées par chacun de ces capteurs sont fournies au module traitement numérique 120 et exploitées par ce dernier pour déterminer au moins une, préférentiellement chacune, des informations suivantes qui est/sont ensuite transmises à l'appareil de gestion/supervision 706 au travers du réseau de communication 708 :
- la tension délivrée par la batterie,
- la capacité nominale de la batterie,
- le courant instantané entrant ou sortant de la batterie,
- la capacité résiduelle de la batterie,
- le nombre de charges,
- le nombre de charges complètes,
- le nombre de décharges,
- le nombre de décharges complètes, et/ou
- la valeur de la capacité résiduelle de la batterie affichée par le pack sur sa jauge, par exemple grâce au moyen de signalisation visuelle 128.

D'autres informations, indépendantes de l'utilisation de la batterie, peuvent également être transmises, telles que par exemple :
- le numéro de série de la batterie,
- la date de fabrication de la batterie,
- la référence de la batterie, et/ou
- la capacité nominale de la batterie.

Ces informations peuvent être préférentiellement transmises sous la forme d'une trame suite à une requête émise par l'appareil de supervision 708.

Les informations transmises à l'appareil de supervision peuvent en outre comprendre au moins une des données suivantes fournie par le système de traitement de données ou le support sur lequel se trouve la batterie :
- une localisation du système mobile ou du support,
- un numéro du système mobile ou du support,
- une donnée d'identification d'un service auquel est associé le système mobile ou le support,
- une donnée d'identification d'un utilisateur/opérateur auquel est associé le support ou le système mobile, et/ou
- la date.

Après traitement par l'appareil de supervision des données relatives à une batterie, au moins une, préférentiellement chacune, des données suivantes peuvent être fournies par l'appareil de supervision:
- une donnée d'alerte visuel/sonore avisant le remplacement de la batterie : cette donnée peut être fournie à opérateur ;
- une donnée d'alerte avisant la mauvaise utilisation de la batterie : cette donnée peut être fournie à l'utilisateur actuelle de la batterie ; et/ou
- une donnée de décharge complète d'une batterie : cette donnée peut être fournie à l'utilisateur actuel de la batterie.

Les données fournies à l'utilisateur de la batterie peuvent être affichées sur un écran faisant partie du système de traitement de données et alimenté par la batterie.

Bien sûr, l'invention n'est pas limitée aux exemples qui viennent d'être décrits et de nombreux aménagements peuvent être apportés à ces exemples sans sortir du cadre de l'invention.

## Revendications

1. Support (300), dit d'alimentation, pour alimenter au moins un appareil de traitement de données, prévu pour accueillir de manière amovible au moins une batterie électrique rechargeable et amovible (100), ladite batterie (100) comprenant :
- au moins un moyen (102) de stockage d'énergie électrique,
- des moyens (106,110,112), dits moyens de liaison électrique de batterie, pour relier électriquement et de manière amovible, ledit moyen (102) de stockage à un dispositif externe pour charger/décharger électriquement ledit moyen (102) de stockage, et
- au moins un moyen (114,116), dit moyen de communication de batterie, pour communiquer, selon au moins un protocole de communication, au moins une donnée numérique relative à ladite batterie à un dispositif externe lorsque ladite batterie (100) est en charge ou en décharge ;
ledit support d'alimentation (300) comprenant un ou plusieurs emplacements (302,304), dit d'accueil, pour recevoir chacun une batterie (100), chaque emplacement (302,304) d'accueil comprenant :
- des premiers moyens de liaison électriques pour réaliser une liaison électrique avec les moyens (106,110,112) de liaison électrique de batterie,
- au moins un premier moyen (318,322 ;320,324) de communication pour communiquer avec le moyen (114,116) de communication de batterie, et
**caractérisé en ce que** ledit support d'alimentation (300) comprend en outre :
- des deuxièmes moyens (316) de liaison électriques pour réaliser, au moins indirectement, une liaison électrique avec ledit appareil de traitement de données pour l'alimenter avec la ou lesdites batteries,
- au moins un deuxième moyen (326 ;328) de communication pour communiquer avec ledit appareil de traitement de données alimenté.

2. Support (300) selon la revendication 1, **caractérisé en ce qu'**au moins un emplacement (302,304) d'accueil, préférentiellement chaque emplacement d'accueil, comprend :
- au moins un moyen (308,312 ;310,314) pour guider une batterie (100) lorsque qu'elle est placée dans ledit emplacement d'accueil ou enlevée dudit emplacement d'accueil, et/ou
- au moins un moyen (308,312 ;310,314) pour maintenir une batterie (100) positionnée dans ledit emplacement d'accueil (302,304)

3. Support (300) selon l'une quelconque des revendications précédentes, **caractérisé en ce que**, pour au moins un emplacement (302,304) d'accueil, les premiers moyens de liaison électrique et/ou le premier moyen (318,322 ;320,324) de communication est/sont disposé(s) sur une surface du fond dudit emplacement (302,304) d'accueil de sorte que lesdits moyens de liaison électrique et/ou ledit premier moyen (318,322 ;320,324) de communication est/sont positionné(s) en contact avec/en regard, respectivement, les/des moyens (110,112) de liaison électrique de batterie et/ou le/du moyen (114,116) de communication de batterie, uniquement sous le poids de ladite batterie (100).

4. Support (300) selon l'une quelconque des revendications précédentes, **caractérisé en ce que**, pour au moins un emplacement d'accueil (302,304), le premier moyen (318,322 ;320,324) de communication comprend un moyen de communication sans fil et le deuxième moyen (326 ;328) de communication comprend un moyen de communication filaire.

5. Système (500) mobile de traitement de données comprenant :
- au moins un appareil (502,504,506) de traitement de données à alimenter, et
- au moins un support (300) d'accueil selon l'une quelconque des revendications 1 à 4 pour accueillir au moins une batterie pour alimenter ledit appareil (502,504,506) de traitement de données.

6. Installation (700) de gestion d'une pluralité de batteries rechargeables et amovibles selon l'une quelconque des revendications 1 à 9, **caractérisé en ce qu'**il comprend :
- au moins un support (710) d'alimentation, selon l'une quelconque des revendications 1 à 4, pour alimenter au moins un appareil de traitement de données avec lesdites batteries rechargeables,
- au moins un support (704) d'accueil, dit de charge, pour charger lesdites batteries rechargeables,
- au moins un appareil (706) distant desdits supports (704 ;710) pour recevoir, au travers d'un réseau (708) de communication, des données en provenance de chacun desdits supports (704 ;710), et
- au moins un module d'analyse pour analyser lesdites données reçues en vue de détecter une anomalie sur une batterie et préconiser une opération relative à ladite batterie.
